# EUROPEAN PATENT APPLICATION

(11) **EP 2 645 496 A1**
(43) Date of publication of application: **02.10.2013**
(21) Application number: 12305350.6
(22) Date of filing: 26.03.2012
(51) Int. Cl.: H01S 5/10

(54) **A wavelength tunable semiconductor laser**

(71) Applicant: Alcatel Lucent, 75007 Paris (FR)
(72) Inventor: Dong, Po, Holmdel, NJ 07733 (US)
(74) Representative: Shamsaei Far, Hassan

(57) **Abstract**

A wavelength tunable laser device (1) comprising a first resonator (11) and a second resonator (12). Each resonator is coupled to respective ends of a first bus waveguide (13) and a second bus waveguide (14) such that the first resonator is coupled to an end of the first bus waveguide and to an end of the second bus waveguide and the second resonator is coupled to another end of the first bus waveguide and another end of the second waveguide. The first and the second bus waveguides are located separately from each other. The laser device further comprises a gain section.

## Description

### TECHNICAL FIELD OF THE INVENTION

The present invention is directed, in general, to optical components.

### BACKGROUND ART

Semiconductor lasers are widely used in optical communications. In particular, single-mode lasers with large wavelength tunability, low prices, and narrow laser linewidth are typically preferable in many WDM based long-haul, metro and access optical networks.

### SUMMARY

It is desired to provide a single-mode semiconductor laser with wider tunability and potentially lower prices and narrower laser linewidth as compared to the known devices. The terms wide tunability or widely tunable as used herein relate to a capability of tuning a wavelength, using thermal effect, by about 5 nanometers or higher.

Some known widely wavelength-tunable laser devices have been proposed based on incorporating gain structures with Bragg gratings or external filters in the device. However, in such devices, the grating structures typically need to be fabricated with sophisticated lithography and etching techniques. Some other known solutions use external filters in order to obtain the desired tunability, however such solutions typically suffer from certain drawbacks. Some of the drawbacks associated with this known structure are that the overall structure of such tunable lasers typically becomes bulky, the cost of manufacturing increases, and in occasions it becomes difficult to integrate the device with other optical components such as electro-optic modulators.

An alternative solution, using ring resonators as narrow bandwidth filters inside a Fabry-Perot cavity has been proposed in a few papers, such as "Wide Tunable Double Ring Resonator Coupled Lasers", B. Liu et al, IEEE PHOTONICS TECHNOLOGY LETTERS, 14, pages 600-602, 2002; and "Full C-Band Tuning Operation of Semiconductor Double-Ring Resonator-Coupled Laser with Low Tuning Current", T. Segawa, et al, IEEE PHOTONICS TECHNOLOGY LETTERS 19, pages 1322-1324, 2007. According to this alternative solution, by using two or more rings with different sizes, wide wavelength tunability can be achieved if each ring is tunable in resonant wavelengths. The ring resonators typically act as narrow-bandwidth filters. However, the tunable lasers with ring filters, as currently known, use input and output facets as reflectors to form laser cavities. The facets typically need to be coated on the resonators to achieve high reflection. This is typically done by air-coating of reflective layers on the facets. The formation of such reflective facets on the ring resonators gives rise to some complexity in the manufacturing process of the lasers with consequent increase in costs. Furthermore, the use of facets in the structure of the device makes it more difficult to integrate the laser with other on-chip optical components such as modulators to form photonics integrated circuits.

Embodiments of the disclosure feature a laser device comprising a first resonator and a second resonator each resonator coupled to respective ends of a first bus waveguide and a second bus waveguide, wherein the first resonator is coupled to an end of the first bus waveguide and to an end of the second bus waveguide and the second resonator is coupled to another end of the first bus waveguide and to another end of the second waveguide, the first and the second bus waveguides being separate from each other; and wherein the laser device further comprises a gain section.

According to some specific embodiments, the resonators are bent optical waveguides.

According to some specific embodiments, the gain section is in at least one of the bus waveguides and is configured to provide gain on an optical field propagating there-through.

According to some specific embodiments, the gain section is in at least one of the resonators and is configured to provide gain on an optical field propagating there-through.

According to some specific embodiments, the gain section comprises gain material configured to provide optical gain for the optical field thereby resulting in a lasing output in the bus waveguide.

According to some specific embodiments, at least one of the bus waveguides comprises a phase elements configured to provide phase matching on an optical field propagating there-through.

According to some specific embodiments the first resonator is configured to receive an optical field from an end of the first bus waveguide and reflect the optical field toward an output of the first resonator coupled at an end of the second bus waveguide.

According to some specific embodiments the first resonator, the second resonator, the first bus waveguide and the second bus waveguide form a closed loop.

According to some specific embodiments the first resonator has a first free spectral range and the second resonator has a second free spectral range, wherein the first spectral range is different from the second free spectral range.

According to some embodiments, the first resonator and the second resonator have substantially identical respective free spectral ranges.

According to some specific embodiments each of the first resonator and the second resonator is a ring resonator or a disk resonator, or a toroid resonator, or a photonic crystal resonator and is configured to perform both narrow-bandwidth filtering and reflecting of the optical field.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figure 1 is an exemplary schematic representation of a widely tunable semiconductor laser according to some embodiments.
Figure 2 is an exemplary graphical representation of tunability response of resonators used in the laser of figure 1.

### DETAILED DESCRIPTION

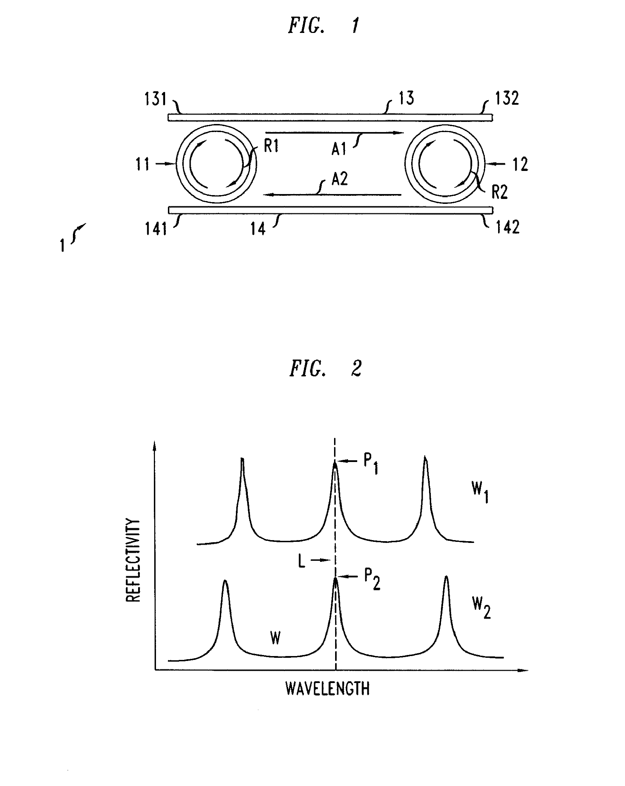

Referring to figure 1, an exemplary schematic representation of a widely tunable laser 1 is shown. The laser 1 comprises a first resonator 11 and a second resonator 12. The first and the second resonators 11 and 12 are coupled to respective ends of a first bus waveguide 13 and a second bus waveguide 14. In the figure, the first bus waveguide 13 is shown to have a first end 131 and a second end 132. The first end 131 is coupled to the first resonator 11 and the second end 132 is coupled to the second resonator 12. Likewise, the second bus waveguide 14 is shown to have a first end 141 and a second end 142. The first end 141 is coupled to the first resonator 11 and the second end 142 is coupled to the second resonator 12. As shown in the figure the first and the second bus waveguides 13 and 14 are located separately from each other.

According to this arrangement, the first resonator 11, the second resonator 12, the first bus waveguide 13 and the second bus waveguide are coupled to each other in a closed-loop configuration.

In some embodiments the resonators are bent waveguides thereby allowing for the optical field received at an input of the resonator, from one bus waveguide, be reflected back - after propagating inside the resonator - and be provided at an output of the resonator to the other bus waveguide.

As is known, the propagation of the optical field inside the resonator causes the optical intensity of the field to amplify due to constructive interference through various round-trips of the optical field inside the resonator waveguide. Only a predetermined wavelength, or wavelengths, match the resonance wavelength of the loop, causing the resonator to operate as wavelength filter. The resonators therefore provide narrow-bandwidth reflections to form a cavity which may be considered as an equivalent structure as a Fabry-Perot cavity. However, contrary to some known solutions, as for example the solutions using ring resonators with reflective facets, the laser cavity as proposed in the present disclosure it is not a standing wave optical cavity but a travelling wave cavity. In other words, the closed-loop configuration of the laser device 1 of the present disclosure comprises a forward path for the propagation of the optical field - for example in the first bus waveguide 13 from the first resonator 11 to the second resonator 12-, and a return path for the propagation of the optical field - for example in the second bus waveguide 14 from the second resonator 12 to the first resonator 11-, where the forward path and the return path are different from each other. This configuration may advantageously contribute to obtaining narrower laser linewidth as compared to standing wave cavities.

For the sake of clarity, it is noted that the standing wave cavity, as mentioned above in relation to some known devices, is to be understood to refer to a cavity in which the forward and the return paths of the propagation of the optical field are through the same waveguide, wherein as a result of interferences between the forward travelling waves and the return travelling waves standing waveforms are produced in the cavity.

Based on the above-described structure, one example of the operation of the laser device 1 is provided below.

An optical field which may be generated by spontaneous emission of the gain material propagates in the first bus waveguide 13 (in the figure, from left to right). The optical field may then propagate toward the second resonator 12 as shown by means of arrow A1 and is input therein. Once input into the second resonator 12, the optical field may perform a number of round trip propagations inside the resonator 12 as shown by means of arrow R2. The round-trip propagations of the optical field inside the resonator 12 may cause amplification in the optical intensity of the optical field due to constructive interference. When a predetermined threshold of the intensity of the optical field is reached, the optical field is output from the second resonator 12 and input into the second bus waveguide 14. The optical field then propagates in the bus waveguide toward the first resonator 11 as shown by means of arrow A2 and is input therein. Once input into the first resonator 11, the optical field may perform a number of round trip propagations inside the resonator 11 as shown by means of arrow R1. The round-trip propagations of the optical field inside the resonator 11 may cause amplification in the optical intensity of the optical field due to constructive interference. When a predetermined threshold of the intensity of the optical field is reached, the optical field is output from the first resonator 11 and input into the first bus waveguide 13 thereby initiating a new round of propagation in the forward and return directions as described above. This forward-return propagation of the optical field in the two bus waveguides provides the effect of a lasing cavity which may be considered as similar to a conventional two-mirror Fabry-Perot cavity, or two-mirror resonators, with the exception that in the case of such conventional structures, standing waves are formed, whereas in the laser structure as proposed herein, the forward propagating wave is separated from the backward propagating wave into two separate bus waveguides 13 and 14 (so the above-described standing waves are absent).

The first resonator and the second resonator may be made according to various configurations as long as such configurations are compatible with the functionalities of resonators as described herein and in particular are configured to perform both narrow-bandwidth filtering and reflecting of the optical field. For example each resonator may be a ring resonator, a disk resonator, a toroid resonator or a photonic crystal resonator. Furthermore, a combination of different resonators in the same laser - e.g. one ring and one toroid resonator - is also possible.

In some preferred embodiments, the resonators may have different free spectral ranges (FSRs), *i.e.* wavelength difference between two neighboring optical modes. In some embodiments, such difference may be achieved by a difference in the size of the first and the second resonator.

Figure 2 shows a graphical representation of tunability response of resonators used in the laser device as proposed herein. This figure is a simulation of reflectivity responses of two ring resonators with different sizes, thereby with different FSRs. The reflectivity response of the first resonator is denoted as waveform W1 and the reflectivity response of the second resonator is denoted as waveform W2. As a result of the different FSRs, the lasing mode selects the wavelength which is closest (or closer) to the resonance wavelength of the two resonators. In figure 2 this is shown with respect to the central peaks P1 of waveform W1 and P2 of waveform W2. The lasing wavelength is represented by the broken line L.

In this manner, by tuning the resonant wavelengths of the two resonators, wide tunability is achievable even when the individual FSRs are not large values. In the context of the present disclosure, an FSR value which is larger than a few nanometers, it is considered a large value. Large FSR values typically require relatively smaller ring radii, thus increasing fabrication complexities. This effect is known as the so-called Vernier effect in the two resonators which is used in order to obtain large wavelength tunability by tuning the resonant wavelengths. The wavelength tunability is performed to tune either one or both the resonant wavelengths of the resonators and wide tunability is obtained by the Vernier effect provided by two resonators.

In some embodiments, the resonators may have substantially identical free spectral ranges (FSRs). Should this be the case, the tunability may depend on the value of the FSRs. Therefore, in order to obtain wide tunability, use may be made of resonators with large FSR values.

In some embodiments, at least one bus waveguide 13 and 14 comprises a respective gain section. The gain section comprises a gain material and is configured to provide optical gain to the optical field thereby resulting in a lasing output in the bus waveguide.

In some embodiments, at least one resonator 11 and 12 comprises a respective gain section.

In some embodiments, at least one bus waveguide 13 and 14 comprises a respective phase element configured to provide phase matching. The phase element may be provided in any known manner. Fore example the phase element may comprise a waveguide with a heat source nearby, or a waveguide with p-i-n junction so that injecting currents may be used to tune the phase,

In some embodiments, a bus waveguide 13 and 14 may comprise a respective gain section and a respective phase element.

In some embodiments one bus waveguide may have a gain section and another bus waveguide may have a phase element or it may have neither a gain section nor a phase element.

The first and the second resonator and the first and the second bus waveguides may be made in InP based and GaAs based III-V substrates. Some of the non-exhaustive advantages of the single mode laser device proposed herein as compared to known devices using ring resonators are the following:
- The laser device as proposed herein does not require any facet reflection in order to ensure laser cavity functionality. This makes the proposed laser device structure to be more compact and comparatively easier to integrate with other integrated optical components during manufacturing processes. As it is known, capability for integration is an important feature in the manufacturing of modern optical devices.
- The laser cavity of the laser device as proposed herein uses two resonators which act as reflectors in which optical fields propagate multiple round trips - through two separate bus waveguides - providing the possibility of obtaining narrower laser linewidth, as compared to the known devices.
- The laser device as proposed herein may be manufactured at comparatively lower cost as it does not require advanced lithography such as Ebeam and deep UV lithography and, as mentioned above, it does not require reflective facet coatings.

The various embodiments of the present invention may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the invention.

## Claims

1. A laser device comprising a first resonator and a second resonator each resonator coupled to respective ends of a first bus waveguide and a second bus waveguide, wherein the first resonator is coupled to an end of the first bus waveguide and to an end of the second bus waveguide and the second resonator is coupled to another end of the first bus waveguide and to another end of the second waveguide, the first and the second bus waveguides being separate from each other; and wherein the laser device further comprises a gain section.

2. The laser device of claim 1, wherein the resonators are bent optical waveguides.

3. The laser device of claim 1 or claim 2, wherein the gain section is in at least one of the bus waveguides and is configured to provide gain on an optical field propagating there-through.

4. The laser device of claim 1 or claim 2, wherein the gain section is in at least one of the resonators and is configured to provide gain on an optical field propagating there-through.

5. The laser device of any one of the preceding claims, wherein the gain section comprises gain material configured to provide optical gain for the optical field thereby resulting in a lasing output in the bus waveguide.

6. The laser device of claim 1 or claim 2, wherein at least one of the bus waveguides comprises a phase element configured to provide phase matching on an optical field propagating there-through.

7. The laser device of any one of the previous claims, wherein the first resonator is configured to receive an optical field from an end of the first bus waveguide and reflect the optical field toward an output of the first resonator coupled at an end of the second bus waveguide.

8. The laser device of any one of the previous claims, wherein the first resonator, the second resonator, the first bus waveguide and the second bus waveguide form a closed loop.

9. The laser device of any one of the previous claims, wherein the first resonator has a first free spectral range and the second resonator has a second free spectral range, wherein the first spectral range is different from the second free spectral range.

10. The laser device of any one of the previous claims 1 to 8, wherein the first resonator and the second resonator have substantially identical respective free spectral ranges.

11. The laser device of any one of the previous claims, wherein each of the first resonator and the second resonator is a ring resonator or a disk resonator, or a toroid resonator, or a photonic crystal resonator, and is configured to perform both narrow-bandwidth filtering and reflecting of the optical field.

12. An optical apparatus comprising the laser device of any one of claims 1 to 11.
